# EUROPEAN PATENT SPECIFICATION

(11) **EP 1 925 966 B1**
(45) Date of publication and mention of the grant of the patent: **28.07.2010**
(21) Application number: 07121525.5
(22) Date of filing: 26.11.2007
(51) Int. Cl.: G02F 1/095, H01S 5/026, G02B 6/26

(54) **Integrated optical isolator including a Bragg grating**
Integrierter optischer Isolator mit einem Bragg-Gitter
Isolateur optique intégré comportant un réseau de Bragg

(30) Priority: 27.11.2006 FR 0610344
(43) Date of publication of application: 28.05.2008
(73) Proprietor: Alcatel Lucent, 75008 Paris (FR); THALES, 92526 Neuilly sur Seine (FR)
(72) Inventor: Dagens, Béatrice, 92160 ANTONY (FR); Van Wolleghem, Mathias, 9040 ST AMANDSBERG (BE); Gogol, Philippe, 75008 PARIS (FR); Beauvillain, Pierre, 75008 PARIS (FR)
(74) Representative: Shamsaei Far, Hassan

(56) References cited:
- EP-A2- 0 142 895
- VAN PARYS WOUTER ET AL: "Transverse magnetic mode nonreciprocal propagation in an amplifying AlGaInAs/InP optical waveguide isolator" APPLIED PHYSICS LETTERS, AIP, AMERICAN INSTITUTE OF PHYSICS, MELVILLE, NY, US, vol. 88, no. 7, 15 February 2006 (2006-02-15), pages 71115-71115, XP012082828 ISSN: 0003-6951
- JACOB M HAMMER ET AL: "Polycrystalline-Metal-Ferromagnetic Optical Waveguide Isolator (POWI) for Monolithic-Integration with Diode-Laser Devices" IEEE PHOTONICS TECHNOLOGY LETTERS, IEEE SERVICE CENTER, PISCATAWAY, NJ, US, vol. 9, no. 5, May 1997 (1997-05), XP011048686 ISSN: 1041-1135
- WESTPHALEN ANDREAS ET AL: "Bragg magneto-optical Kerr effect measurements at Co stripe arrays on Fe(001)" JOURNAL OF APPLIED PHYSICS, AMERICAN INSTITUTE OF PHYSICS. NEW YORK, US, vol. 97, no. 7, 22 March 2005 (2005-03-22), pages 73909-73909, XP012070974 ISSN: 0021-8979

## Description

The field of the invention is that of optical devices comprising a semiconductor laser emission source and an optical isolator. These devices are used mainly in the field of high-data-rate digital telecommunications.

It is known that a laser source may be made unstable by a parasitic optical beam going from the initial emission beam and reflected by an optical surface external to the laser cavity and re-injected into the laser cavity. To reduce this phenomenon, two solutions are possible.

The first solution consists in modifying the structure of the laser source so as to reduce its sensitivity to optical return signals. For this purpose, it is possible to use DFB (distributed feedback) lasers. It is also possible to place an optical isolator at the exit of the laser. The function of the isolator is to let the light coming from the laser pass through it while eliminating any parasitic light coming in the opposite direction.

An optical isolator works on the principle of a non-reciprocal optical effect for providing this function. It generally uses the Faraday effect. This magnetooptical effect consists of a rotation of the linear polarization of the light passing through a ferromagnetic material. Thus, by positioning this type of material between suitably placed polarizers it is possible to transmit the light propagating in a first direction and to block it in the opposite direction. However, these devices are poorly suited to optical devices that include semiconductor lasers, in so far as they require a certain number of components that are not easy to integrate into devices whose dimensions are of the order of 1 millimetre.

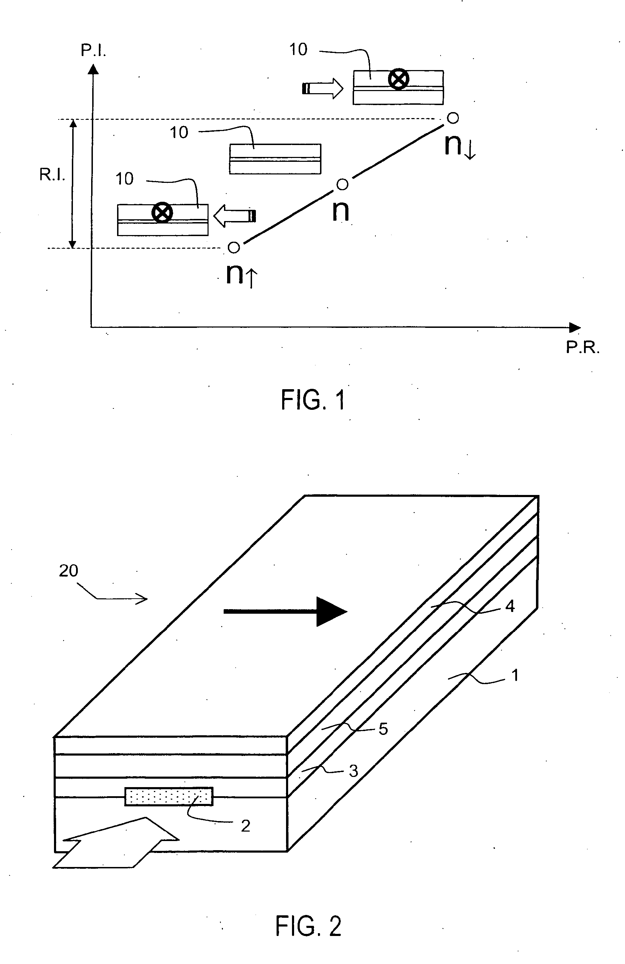

Finally, it is possible to use optical isolators undergoing non-reciprocal absorption of a guided mode using the magnetooptic Kerr effect. It is known that the effective optical index of the guided mode is complex. It comprises a real part and an imaginary part that is proportional to the absorption of the material. Now, in the presence of a ferromagnetic material with a remanent magnetization, the effective optical index of the TM (transverse magnetic) polarized guide mode depends on the direction of propagation of the light. Figure 1 shows the variations in the real and imaginary parts of the effective optical index of the guided mode of the transverse magnetic optical mode of this type of material as a function of the direction of propagation of the light. In the absence of magnetization, the optical index in the material 10 is equal to n. In the presence of magnetization shown symbolically by a black circle containing a cross, in the direction of propagation of the light shown symbolically by a scored arrow coming from the right, the effective index n of the guided mode becomes n↑ in a first direction of propagation and n↓ in the opposite direction. The difference between the two imaginary parts IP of the indices n↑ and n↓ gives the isolation ratio IR. Consequently, a light beam will be absorbed to a greater or lesser extent by this type of material depending on its direction of propagation.

The latter isolators are well suited to be integrated into optical devices that include a semiconductor laser source. In this case, they are generally integrated into an amplifying structure of the SOA (semiconductor optical amplifier) type. The document Van Parys Wouter et al: "Transverse magnetic mode nonreciprocal propagation in an amplifying AlgaAs/inP optical waveguide isolator" Applied Physics Letters, AIP, American Institute of Physics, Melville, NY, US, vol. 88, N° 7, 15 february 2006, pages 71115, XP012082828 ISSN 6951 discloses an optoelectronic device comprising a magnetooptic material exhibiting a Kerr effect. Thus, the optical amplification provided by the SOA compensates, in a first direction of propagation, for the lower absorption of the material. In the opposite direction of propagation, the absorption remains predominant and attenuates the light beam so as to prevent return signals.

In the latter case, the optical isolator 20 generally has a BRS (Buried Ridge Stripe) structure. The sectional diagram of such a structure is shown in Figure 2. It essentially comprises, in succession:
- a substrate 1 made of an n-doped InP semiconductor material common with that of the laser;
- an active part 2, also common with that of the laser;
- a layer 3 of p-doped semiconductor material. This layer, also common with that of the laser, is however, in the isolator part, of much smaller thickness so that the magnetic field is as close as possible to the active layer. Its thickness does not exceed a few tenths of a micron;
- an electrical contact layer (not shown in the figures) placed beneath the first substrate 1 and an upper electrical contact layer 5 placed on the second substrate 3. The electrodes are placed on these contact layers. The electrodes bring the current needed to amplify the laser radiation; and
- a layer of magnetooptic material 4 which may for example be an iron-cobalt alloy. Magnetization direction of the material is shown symbolically by an arrow in Figure 2. This layer both magnetizes the active layer and provides the electrical contact.

The optical beam emitted by the semiconductor laser propagates through the active layer common to the laser and to the isolator. It is shown by a white arrow in Figure 2.

This configuration makes it possible to ensure both amplification of the light beam coming from the semiconductor laser and absorption of the parasitic light coming in the opposite direction to the direction of propagation. However, current materials do not allow completely satisfactory isolation ratios to be achieved. Thus, an isolator whose magnetic layer is made of Fe-Co and has a length of 2 millimetres has an insertion loss of about 11 dB when a 150 mA current is applied to it. With the current materials, even though it is possible to extend the length of the isolator further, it appears that the situation is close to maximum performance. This is because the performance of an isolator results from a necessary compromise between the optical confinement factor in the magnetic layer that induces optical losses and the gain of the amplifying structure that has to compensate for these losses.

The operating principle of these isolators is based on the non-reciprocal variation of the imaginary part of the effective optical index of the guided mode. The novel idea employed in the devices according to the invention is, on the one hand, to base the operation of the device also on the non-reciprocal variation of the real part of the optical index and, on the other hand, to amplify this variation using a particular optical arrangement.

More precisely, the subject of the invention is an optoelectronic device comprising at least one optical waveguide in the stripe form, in which an optical wave can propagate at a first given wavelength, said device also including a plane diffraction grating coupled to said optical waveguide, characterized in that said grating is made of a magnetooptic material exhibiting a Kerr effect and includes a series of periodically spaced structures causing periodic optical confinement in the magnetooptic material, the effective index of the guided mode having a first value in a first direction of propagation of the optical wave and a second value in the opposite direction, the shape, the pitch, the number of structures and the optical index difference being such that, in a first direction of propagation of the optical wave, the grating has a low reflection coefficient and, in the opposite direction of propagation of the optical wave, the grating has a high reflection coefficient, so as to achieve optical isolation with respect to the propagation wave.

The document Westphalen Andreas et al: "Bragg magneto-optical Kerr effect measurements at Co stripe arrays on Fe(001)" Journal of Applied Physics, American Institute of Physics, new-York, US, vol. 97, Nà 7, 22 March 2005, pages 73909-73909, XP012070974 ISSN:0021-8979 discloses a diffraction grating having magneto-optical properties. However, the reflexion on the grating is external to the device and does not apply to an isolator.

Advantageously, the grating/optical waveguide assembly constitutes an optical isolator, the shape, the pitch, the number of structures and the optical index difference of the grating being such that:
- in the first direction of propagation of the optical wave, the reflection coefficient of the grating as a function of the wavelength is a symmetrical curve centred on a second wavelength different from that of the optical wave and with a spectral width smaller than the difference between the first wavelength and the second wavelength; and
- in the opposite direction of propagation of the optical wave, the reflection coefficient of the grating as a function of the wavelength is a symmetrical curve centred on a third wavelength and with a spectral width greater than the difference between the first wavelength and the third wavelength.

Advantageously, the device also includes an amplifying structure of the SOA type integrated into the isolator.

Advantageously, the device also includes a semiconductor laser produced on the same substrate as the isolator, the diffraction grating serving as a Bragg mirror for the laser.

Advantageously, the entire device is produced on a semiconductor substrate.

Advantageously, the plane of the diffraction grating is substantially either parallel or perpendicular to the plane of the waveguide.

Advantageously, the isolator is made on a semiconductor substrate and the ferromagnetic material exhibiting the Kerr effect is an iron alloy or an iron-cobalt alloy or a manganese-based alloy or a manganese-based semiconductor or an optionally doped iron garnet.

The invention will be more clearly understood and further advantages will become apparent on reading the following description given by way of nonlimiting example and in conjunction with the appended figures in which:
- Figure 1 shows the variations of the effective optical index of the guided mode as a function of the direction of propagation of the light, the structure of the waveguide including a magnetooptic material magnetized in opposite directions;
- Figure 2 shows a perspective view of an optoelectronic device that includes an isolator according to the prior art;
- Figures 3 and 4 show the variations of the reflection coefficient of a non-reciprocal diffraction grating as a function of the wavelength, in a propagation direction and in the opposite direction;
- Figure 5 shows the operating principle of an isolator with a grating according to the invention; and
- Figure 6 shows a perspective view of an optoelectronic device that includes an isolator according to the invention.

The isolating devices according to the invention are based on two principles:
- firstly, the operation of the device is based on the non-reciprocal variation of the real part of the effective optical index of the guided mode; and
- secondly, this variation is amplified using a diffraction grating.

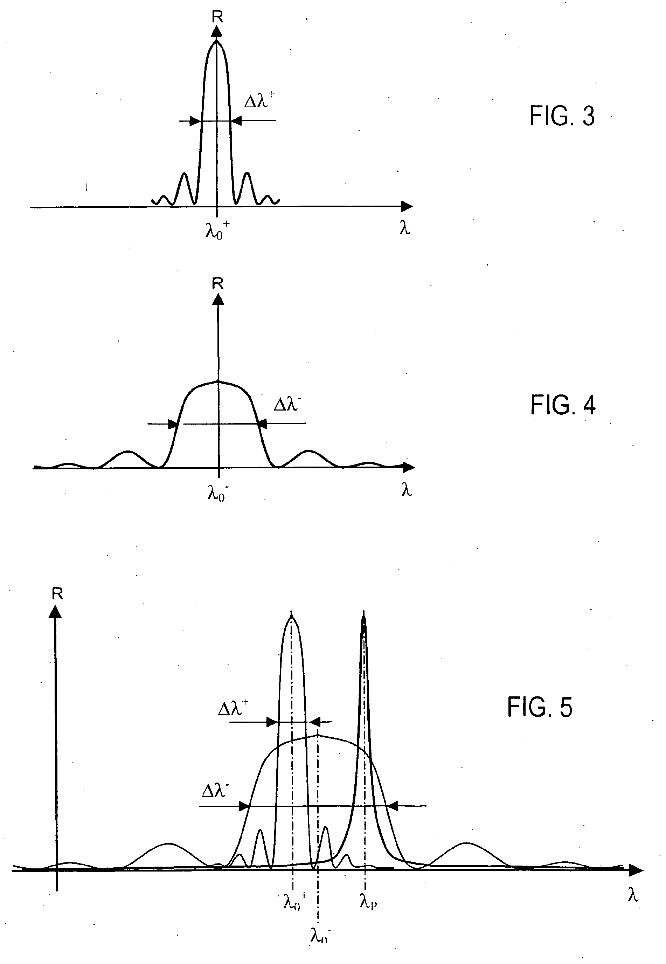

In general, a diffraction grating comprises a series of regularly spaced structures, the distance separating two successive structures being called the pitch of the grating. These structures are generally identical for any grating. Knowing the geometrical shape, the optical index, the period and the number of the structures, it is easily possible to calculate the reflection coefficient as a function of the wavelength. Generally, it is characterized by a central wavelength and a spectral width. At the central wavelength, the reflection coefficient of the grating is a maximum. The spectral width corresponds to the width of the spectrum such that the reflection coefficient of the grating is at least equal to half the maximum reflection coefficient. Of course, if the optical index of the materials used for producing the grating varies, the reflection coefficient R as a function of the wavelength λ, also varies. Thus, the curves shown in Figures 3 and 4 are obtained.

In Figure 3, the effective optical index of the guided mode has a first value. The parameters of the grating are such that the grating is perfectly tuned to a central wavelength λ₀⁺. At this wavelength, the reflection coefficient R is a maximum and the spectral width Δλ⁺ of the curve representing the reflection coefficient as a function of the wavelength is narrow.

In Figure 4, the effective optical index of the guided wave has a second value. At the central wavelength λ₀⁻, the reflection coefficient R is lower. Conversely, the spectral width Δλ⁻ of the curve representing the reflection coefficient as a function of the wavelength has broadened.

These properties of the gratings may be used to produce various optical isolation devices. Using for example these magnetized ferromagnetic materials with a strong magnetooptic effect to produce the grating and by adjusting the various parameters of the grating, it is possible to obtain a grating whose variations of the reflection coefficient in a first direction of propagation are those of Figure 3 and in the opposite direction of propagation those shown in Figure 4.

To give a first example, an autonomous optical isolator with the operating principle indicated in Figure 5 may be produced. The central wavelengths λ₀⁺ and λ₀⁻ of the grating are therefore judiciously chosen in such a way that:
- in the direction of propagation, since the spectral width Δλ⁺ is smaller than the difference between the propagation wavelength λ_{P} and the central wavelength λ₀⁺ of the grating, said grating has a low reflection coefficient R; and
- in the opposite direction of propagation, since the spectral width Δλ⁻ is greater than the difference between the propagation wavelength λ_{P} and the central wavelength λ₀⁻ of the grating, said grating has a high reflection coefficient R.

The desired isolation effect is thus obtained.

To give a second example, it is also possible to produce a semiconductor laser that integrates the isolation function by replacing the Bragg mirror having an isotropic optical index of the cavity, the reflection properties of which are independent of the direction of propagation of the wave, by a grating according to the invention. It is thus possible to isolate the wave propagating in the cavity from the external waves that propagate in the other direction.

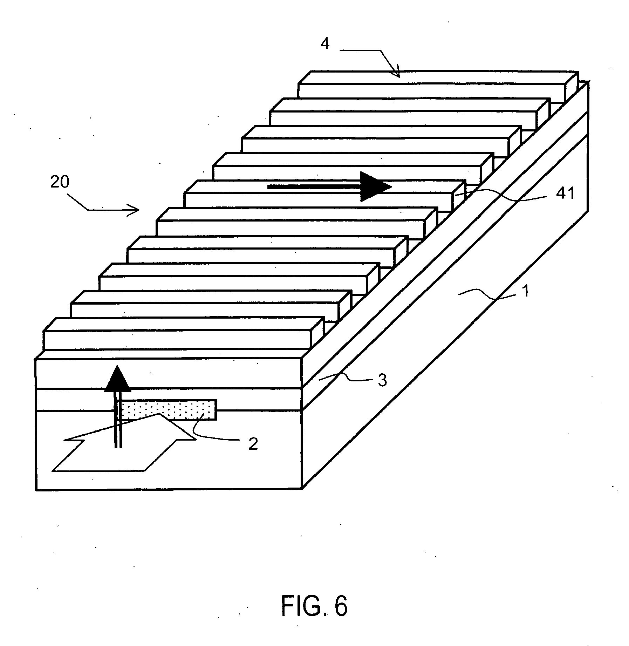

The production of an isolator structure with a non-reciprocal grating according to the invention poses no particular technical problems. To give a non-limiting example, Figure 6 shows a perspective view of an SOA-type optoelectronic device that includes an isolator according to the invention. It essentially comprises, in succession:
- a substrate 1 made of n-doped InP semiconductor material;
- an active part in the form of a stripe 2;
- a layer 3 made of p-doped semiconductor material. This layer has a small thickness so that the magnetic field is as close as possible to the active layer. Its thickness does not exceed a few tenths of a micron; and
- a grating 4 made of a magnetooptic material which may for example be an iron-cobalt alloy. Other materials and other alloys produced from iron, cobalt or manganese are, of course, possible. For example, a manganese-based semiconductor or an optionally doped iron garnet may be used. The magnetization of the material is shown symbolically by an arrow in Figure 2. The latter layer provides both magnetization of the active layer and the electrical contact. The average direction of the structures 41 constituting this grating is perpendicular to the average direction of the strip of the active part 2.

The optical beam emitted by the semiconductor laser propagates through the active layer common to the laser and to the isolator and the electrical contact layer. It is represented by a white arrow in Figure 6. In this case, the polarization of the optical beam represented by a double-shafted arrow in Figure 6 is perpendicular to the mean plane of the layers. The grating may for example be produced by directly etching the Fe-Co magnetooptic layer.

As indicated in Figure 6, the plane of the diffraction grating may be substantially parallel to the plane of the waveguide. In this case, the current must be injected laterally. It is also possible to etch the grating so that the plane of the diffraction grating is substantially perpendicular to the plane of the waveguide, it then being possible for the entire device to be a deep-ridge structure.

## Claims

1. Optoelectronic device comprising at least one optical waveguide (2) in the stripe form, in which an optical wave can propagate at a first given wavelength and an optical isolator comprising a magnetooptic material exhibiting a Kerr effect, **characterized in that** said device also including a plane diffraction grating (4) coupled to said optical waveguide, the said grating is made of the magnetooptic material exhibiting the Kerr effect and includes a series of uniformly spaced identical structures (41) causing periodic optical confinement in the layer of magnetooptic material exhibiting a Kerr effect, the effective index of the guided mode having a first value in a first direction of propagation of the optical wave and a second value in the opposite direction, the shape, the pitch, the number of structures and the optical index difference being such that, in a first direction of propagation of the optical wave, the grating has a low reflection coefficient (R) and, in the opposite direction of propagation of the optical wave, the grating has a high reflection coefficient (R), so as to achieve optical isolation with respect to the propagation wave.

2. Optoelectronic device according to Claim 1, **characterized in that** the grating/optical waveguide assembly constitutes an optical isolator (20), the shape, the pitch, the number of structures and the optical index difference of the grating being such that:
• in the first direction of propagation of the optical wave, the reflection coefficient of the grating as a function of the wavelength is a symmetrical curve centred on a second wavelength different from that of the optical wave and with a spectral width smaller than the difference between the first wavelength and the second wavelength; and
• in the opposite direction of propagation of the optical wave, the reflection coefficient of the grating as a function of the wavelength is a symmetrical curve centred on a third wavelength and with a spectral width greater than the difference between the first wavelength and the third wavelength.

3. Optical device according to Claim 2, **characterized in that** the device also includes an amplifying structure of the SOA type integrated into the isolator.

4. Optical device according to Claim 1, **characterized in that** the device also includes a semiconductor laser produced on the same substrate, the diffraction grating serving as a Bragg mirror for the laser.

5. Optical device according to one of the preceding claims, **characterized in that** the entire device is produced on a semiconductor substrate.

6. Optical device according to one of the preceding claims, **characterized in that** the plane of the diffraction grating is substantially parallel to the plane of the waveguide.

7. Optical device according to one of Claims 1 to 5, **characterized in that** the plane of the diffraction grating is substantially perpendicular to the plane of the waveguide, the entire device being a structure of the deep-ridge type.

8. Optical device according to one of the preceding claims, **characterized in that** the magnetooptic material exhibiting the Kerr effect is an iron-based alloy or a cobalt-based alloy or a manganese-based alloy or a manganese-based semiconductor or an optionally doped iron garnet.

## Patentansprüche

1. Optoelektronische Einrichtung, mindestens einen optischen Wellenleiter (2) in Streifenform umfassend, in dem sich eine optische Wolle mit einer ersten gegebenen Wellenlänge kann, und einen optischen isolator, der ein einen Ker"-Effekt aufweisendes magnetooptisches Material umfasst, **dadurch gekennzeichnet, dass** die Einrichtung auch ein ebenes Beugungsgitter (4) enthält, das an den optischen Wellenleiter gekoppelt ist, wobei das Gitter aus dem den Kerr-Effekt aufweisenden magnetooptischen Material hergestellt ist und eine Reihe von gleichmaßig beabstandeten identischen Strukturen (41) enthält, die in der einen Kerr-Effekt aufweisenden magnetooptischen Materialschicht periodisches optisches Confinement verursachen, wobei der effektive Index der geführten Mode in einer ersten Ausbreitungsnchtung der optischen Welle einen ersten Wert und in der entgegengesetzten Richtung einen zweiten Wert hat, wobei die Form, der Abstand, die Anzahl der Strukturen und die optischen Indexdifferenz so sind, dass in einer ersten Ausbreitungsrichtung der optischen Welle das Gitter einen niedrigen Reflexionskoeffizienten (R) hat und in der entgegengesetzten Ausbreitungsrichtung der optischen Welle das Gitter einen hohen Reflexionskoeffizienten (R) hat, damit optische Isolation mit Bezug auf die Ausbreitungswelle erzielt wird.

2. Optoelektronische Einrichtung nach Anspruch 1, **dadurch gekennzeichnet, dass** die Gatter-/optische Wellenleiter-Baugruppe einen optischen Isolator (20) bildet, wobei die Form, der Abstand, die Anzahl der Strukturen und die optische Indexdifferenz des Gitters so sind, dass:
- in der ersten Ausbreitungsrichtung der optischen Welle der Reflexionskoeffizient des Gitters als eine Funktion der Wellenlänge eine symmetrische Kurve ist, die auf einer zweiten Wellenlänge zentriert ist, die von der der optischen Weile verschiedenen ist, und mit einer Spektralbreite, die kleiner ist als die Differenz zwischen der ersten Wellenlänge und der zweiten Wellenlänge; und
- in der entgegengesetzten Ausbreitungsrichtung der optischen Welle der Reflexionskoeffizient des Gitters als eine Funktion der Wellenlänge eine symmetrische Kurve ist, die auf einer dritten Wellenlänge zentriert ist, und mit einer Spektralbreite, die größer ist als die Different zwischen der ersten Wellenlänge und der dritten Wellenlänge.

3. Optische Einrichtung nach Anspruch 2, **dadurch gekennzeichnet, dass** die Einrichtung auch eine in den Isolator integrierte Verstärkungsstruktur des SOA-, Typs (optischer Halbleiterverstärker) enthält.

4. Optische Einrichtung nach Anspruch 1, **dadurch gekennzeichnet, dass** die Einrichtung auch einen auf demselben Substrat hergestellten Halbleiterlaser enthält, wobei das Beugungsgitter dem Laser als ein Bragg-Spiegel dient.

5. Optische Einrichtung nach einem der vorhergehenden Ansprüche, **dadurch gekennzeichnet, dass** die gesamte Einrichtung auf einem Halbleitersubstrat hergestellt ist.

6. Optische Einrichtung nach einem der vorhergehenden Ansprüche, **dadurch gekennzeichnet, dass** die Ebene des Beugungsgitters im Wesentlichen parallel zur Ebene des Wellenleiters verläuft.

7. Optische Einrichtung nach einem der Ansprüche 1 bis 5, **dadurch gekennzeichnet, dass** die Ebene des Beugungsgitters im Wesentlichen senkrecht zur Ebene des Wellenleiters verläuft, wobei die gesamte Einrichtung eine Struktur vom Typ "Deep-Ridge" (tiefe Rippenstruktur) ist.

8. Optische Einrichtung nach einem der vorhergehenden Ansprüche, **dadurch gekennzeichnet, dass** das den Kerr-Effekt aufweisenden magnetooptische Material eine eisenbasierte Legierung oder eine kobaltbasierte Legierung oder eine manganbasierte Legierung oder ein manganbasierter Halbleiter oder ein optional dotierter Eisengranat ist.

## Revendications

1. Dispositif opto-électronique comprenant au moins un guide optique (2) en forme de ruban dans lequel une onde optique peut se propager à une première longueur d'onde donnée, ledit dispositif composant également une couche de matériau magnéto-optique à effet Kerr et un réseau de diffraction plan (4) couplé avec ledit guide optique, **caractérisé en ce que** ledit réseau comportant une série de structures (41) identiques régulièrement espacées induisant un confinement optique périodique dans la couche de matériau magnéto-optique à effet Kerr, l'indice effectif du mode guidé ayant une première valeur dans un premier sens de propagation de ronde optique et une seconde valeur dans le sens opposé, a forme, le pas, le nombre des structures et la différence d'indice optique étant tels que, dans un premier sens de propagation de l'onde optique, le réseau a un coefficient de réflexion (R) faible et que dans le sens de propagation opposé de l'onde optique, le réseau a un coefficient de reflexion (R) élevé, de façon à réaliser une isolation optique vis-à-vis de l'onde de propagation.

2. Dispositif opto-électronique selon la revendication 1, **caractérisé en ce que** l'ensemble guide optique-réseau constitue un isolateur optique (20), la forme, le pas, le nombre des structures et la différence d'indice optique du réseau étant tels que:
• dans le premier sens de propagation de l'onde optique, le coefficient de réflexion du réseau en fonction de la longueur d'onde est une courbe symétrique centrée sur une seconde longueur d'onde différente de celle de l'onde optique et d'une largeur spectrale inférieure à la différence entre la première longueur d'onde et la seconde longueur d'onde,
• dans le sens de propagation opposé de l'onde optique, le coefficient de réflexion du réseau en fonction de la longueur d'onde est une courbe symétrique centrée sur la même seconde longueur d'onde et d'une largeur spectrale supérieure à la différence entre la première longueur d'onde et la seconde longueur d'onde.

3. Dispositif optique selon la revendication 2, **caractérisé en ce que** le dispositif comporte également une structure amplificatrice de type SOA intégrée à l'isolateur.

4. Dispositif optique selon la revendication 1, **caractérisé en ce que** le dispositif comporte également un laser à semi-conducteur réalisé sur le même substrat, le réseau de diffraction servant de miroir de Bragg pour le laser.

5. Dispositif optique selon l'une des revendications précédentes, **caractérisé en ce que** l'ensemble du dispositif est réalise sur un substrat semi-conducteur.

6. Dispositif optique selon l'une des revendications précédentes, **caractérisé en ce que** le plan du réseau de diffraction est substantiellement parallèle au plan du guide d'onde.

7. Dispositif optique selon l'une des revendications 1 à 5, **caractérisé en ce que** le plan du réseau de diffraction est substantiellement perpendiculaire au plan du guide d'onde, l'ensemble du dispositif étant une structure de type « deep-rîdge ».

8. Dispositif optique selon l'une des revendications précédentes, **caractérisé en ce que** le matériau magnéto-optique à effet Kerr est ou un alliage à base de fer ou un alliage à base de cobalt ou un alliage à base de manganèse ou un semicondudeur à base de manganèse ou un grenat de fer éventuellement dopé,
